# EUROPEAN PATENT APPLICATION

(11) **EP 1 889 945 A1**
(43) Date of publication of application: **20.02.2008**
(21) Application number: 05822366.0
(22) Date of filing: 27.12.2005
(51) Int. Cl.: C23C 16/40, H01B 13/00, H01L 31/04

(54) **METHOD FOR PRODUCING ZnO-BASED TRANSPARENT ELECTROCONDUCTIVE FILM BY MOCVD (METAL ORGANIC CHEMICAL VAPOR DEPOSITION) METHOD**

(30) Priority: 28.12.2004 JP 2004380559
(71) Applicant: Showa Shell Sekiyu Kabushiki Kaisha, Minato-ku Tokyo 1358074 (JP)
(72) Inventor: KURIYAGAWA, Satoruc/o Showa Shell Sekiyu K.K, Tokyo 135-8074 (JP); TANAKA, Yoshiakic/o Showa Shell Sekiyu K.K, Tokyo 135-8074 (JP)
(74) Representative: HOFFMANN EITLE
(86) International application number: PCT/JP2005/023892
(87) International publication number: WO 2006/070799

(57) **Abstract**

The triethylaluminum contained as an impurity in low-purity raw-material diethylzinc, which is inexpensive, is utilized as an additive to reduce the cost of film formation.

Diethylzinc having a low purity (99.99-98% or 99.99-90%) is used as a raw material to produce a ZnO transparent conductive film by the MOCVD (metal-organic chemical vapor deposition) method. Water vapor (H₂O) is used as an oxidizing agent and the triethylaluminum contained as an impurity in the rawmaterial is utilized as an additive (diborane is further added as an additive) to cause the diethylzinc, the water vapor (H₂O), and the triethylaluminum (and the diborane) to undergo a vapor-phase reaction to produce a ZnO transparent conductive film.

## Description

### TECHNICAL FIELD

The present invention relates to a process for producing a ZnO transparent conductive film for use in CIS type thin-film solar cells, etc.

### BACKGROUND ART

A process for forming a transparent conductive film is known in which a transparent conductive film for solar cells, etc. is formed by the chemical vapor deposition method (CVD method) (see, for example, patent document 1). This process comprises introducing an organozinc compound (e.g., diethylzinc) as a raw material, an oxidizing agent (e.g., water or water vapor), and additives (e.g., triethylaluminum as aluminum and diborane as boron) into a reaction chamber containing a substrate heated to about 60-350°C, preferably 100-200°C (specifically about 150°C), to thereby form a zinc oxide film on the substrate. The addition of Group-III elements (e.g., triethylaluminum as aluminum and diborane as boron) to zinc oxide reduces resistivity. A zinc oxide film containing hydrogen has lower thermal stability than a zinc oxide film containing aluminum, while the zinc oxide film containing aluminum has a slightly higher resistivity than the zinc oxide film containing hydrogen. Although patent document 1 discloses the use of diethylzinc as a raw-material organozinc compound, it includes no statement concerning the purity of the raw material.

Patent Document 1: JP-B-6-14557

In general, in the case of forming a ZnO transparent conductive film by the chemical vapor deposition method (CVD method), diethylzinc having a purity of 99.999-99.9999%, which is called semiconductor-grade purity, is used as a raw material. Because of the necessity of a purification step for removing impurities, the cost of the diethylzinc is high. This has been a cause of the high cost of the formation of ZnO transparent conductive films. Furthermore, since diborane, which is added for reducing the resistivity of a ZnO transparent conductive film in the case of forming the ZnO transparent conductive film by the chemical vapor deposition method (CVD method), is a special material gas whose handling necessitates a special apparatus, this has resulted in an increase in production cost.

### DISCLOSURE OF THE INVENTION

### PROBLEMS THAT THE INVENTION IS TO SOLVE

A first object of the invention is to provide a process for forming a ZnO transparent conductive film by the MOCVD (metal-organic chemical vapor deposition) method using inexpensive low-purity diethylzinc (Zn(C₂H₅)₂) as a raw material and thereby reduce the cost of the formation of ZnO transparent conductive films. The ZnO transparent conductive film formed by this process of the invention is equal in performance (resistivity and extinction coefficient) to ZnO transparent conductive films formed from high-purity diethylzinc as a raw material.

A second object of the invention is to reduce the use of an additive and the operation of introduction thereof and reduce the cost of film formation, by utilizing the triethylaluminum (Al(C₂H₅)₃) contained as an impurity in the inexpensive low-purity raw-material diethylzinc as an additive in the film formation by the MOCVD (metal-organic chemical vapor deposition) method. The ZnO transparent conductive film formed by this process of the invention is equal in performance (resistivity and extinction coefficient) to ZnO transparent conductive films formed by a process in which high-purity diethylzinc is used as a raw material and triethylaluminum (Al (C₂H₅)₃) is added.

A third object of the invention is to reduce the cost of the formation of a ZnO transparent conductive film by forming a ZnO transparent conductive film by the MOCVD (metal-organic chemical vapor deposition) method without adding (using) diborane (B₂H₆), which has been used as an additive in related-art deposition methods and is a special material gas whose handling necessitates a special apparatus. The ZnO transparent conductive film formed by this process of the invention is equal in performance (resistivity and extinction coefficient) to ZnO transparent conductive films formed by a process in which high-purity diethylzinc is used as a raw material and diborane (B₂H₆), which is a special material gas whose handling necessitates a special apparatus, is added.

### MEANS FOR SOLVING THE PROBLEMS

(1) The invention, which is for eliminating the problems described above, provides a process for producing a ZnO transparent conductive film in which low-purity diethylzinc (Zn (C₂H₅)₂) is used as a raw material to produce a ZnO transparent conductive film by the MOCVD (metal-organic chemical vapor deposition) method, wherein the process comprises using diethylzinc of 90-99.99% as a raw material and water vapor (H₂O) as an oxidizing agent, utilizing as a Group-III-element additive the triethylaluminum (Al(C₂H₅)₃) contained as an impurity in the diethylzinc in an amount of 0.01-10%, and adding diborane (B₂H₆) as a Group-III-element additive to cause the diethylzinc, the water vapor (H₂O) the triethylaluminum, and the diborane to undergo a vapor-phase reaction and thereby produce a ZnO transparent conductive film by the MOCVD (metal-organic chemical vapor deposition) method. (Deposition Method I: High-purity region is for applications such as current driven devices (large current amounts), e.g., solar cells, and low-purity region is for applications such as voltage driven devices (small current amounts), e.g., liquid-crystal display panels and prevention of static buildup)

(2) The invention provides a process for producing a ZnO transparent conductive film in which low-purity diethylzinc (Zn(C₂H₅)₂) is used as a raw material to produce a ZnO transparent conductive film by the MOCVD (metal-organic chemical vapor deposition) method, wherein the process comprises using diethylzinc of 99.99-98% as a raw material and water vapor (H₂O) as an oxidizing agent, utilizing as a Group-III-element additive the triethylaluminum (Al(C₂H₅)₃) contained as an impurity in the diethylzinc in an amount of 0.01-2%, and adding a slight amount of diborane (B₂H₆) as a Group-III-element additive to cause the diethylzinc, the water vapor (H₂O) the triethylaluminum, and the diborane to undergo a vapor-phase reaction and thereby produce a ZnO transparent conductive film by the MOCVD (metal-organic chemical vapor deposition) method.

### (Deposition Method II: for high-purity region or current driven devices)

(3) The invention provides a process for producing a ZnO transparent conductive film in which low-purity diethylzinc (Zn (C₂H₅)₂) is used as a raw material to produce a ZnO transparent conductive film by the MOCVD (metal-organic chemical vapor deposition) method, wherein the process comprises using diethylzinc of 90-98% as a raw material and water vapor (H₂O) as an oxidizing agent and utilizing as a Group-III-element additive the triethylaluminum (Al (C₂H₅)₃) contained as an impurity in the diethylzinc in an amount of 2-10% to cause the diethylzinc, the water vapor (H₂O), and the triethylaluminum to undergo vapor-phase reactions and thereby produce a ZnO transparent conductive film by the MOCVD (metal-organic chemical vapor deposition) method without adding diborane (B₂H₆) as a Group-III-element additive.

### (Deposition Method III: for low-purity region or voltage driven devices)

(4) The invention provides the process as described under (3) above for producing a ZnO transparent conductive film by the MOCVD (metal-organic chemical vapor deposition) method as described under (2) above, characterized in that the deposition is conducted at a substrate temperature of 150-190°C and a flow rate ratio of the carrier gas containing the diethylzinc to the carrier gas containing the water vapor (H₂O) in the range of 0.95-1.05.

### (Deposition Method (III): for low-purity region or voltage driven devices)

(5) The invention provides a process for producing a ZnO transparent conductive film in which low-purity diethylzinc (Zn(C₂H₅)₂) is used as a raw material to produce a ZnO transparent conductive film by the MOCVD (metal-organic chemical vapor deposition) method, wherein the process comprises using diethylzinc of 99.99-98% as a raw material and water vapor (H₂O) as an oxidizing agent and utilizing as a Group-III-element additive the triethylaluminum (Al(C₂H₅)₃) contained as an impurity in the diethylzinc in an amount of 0.01-2% to cause the diethylzinc, the water vapor (H₂O), and the triethylaluminum to undergo vapor-phase reactions and thereby produce a ZnO transparent conductive film by theMOCVD (metal-organic chemical vapor deposition) method without adding diborane (B₂H₆) as a Group-III-element additive.

### (Deposition Method IV: for liquid-crystal display panels, antifogging glasses, and antistatic glasses, and for low-purity region or voltage driven devices)

(6) The invention provides the process as described under (5) above for producing a ZnO transparent conductive film by the MOCVD (metal-organic chemical vapor deposition) method as described under (4) above, wherein the deposition is conducted at a substrate temperature of 160-180°C and a flow rate ratio of the carrier gas containing the diethylzinc to the carrier gas containing the water vapor (H₂O) of about 1.0.

### (Deposition Method IV: for liquid-crystal display panels, antifogging glasses, and antistatic glasses, and for low-purity region or voltage driven devices)

### ADVANTAGES OF THE INVENTION

The invention provides a process for forming a ZnO transparent conductive film by the MOCVD (metal-organic chemical vapor deposition) method using inexpensive low-purity diethylzinc (Zn (C₂H₅)₂) as a raw material and can thereby reduce the cost of the formation of ZnO transparent conductive films. The ZnO transparent conductive film formed by this process of the invention can be equal in performance (resistivity and extinction coefficient) to ZnO transparent conductive films formed from high-purity diethylzinc as a raw material.

The invention can eliminate the use of an additive and the operation of introduction thereof and reduce the cost of film formation, by utilizing the triethylaluminum (Al(C₂H₅)₃) contained as an impurity in inexpensive low-purity raw-material diethylzinc as an additive in film formation by the MOCVD (metal-organic chemical vapor deposition) method. The ZnO transparent conductive film formed by this process of the invention can be equal in performance (resistivity and extinction coefficient) to ZnO transparent conductive films formed by a process in which high-purity diethylzinc is used as a raw material and triethylaluminum (Al(C₂H₅)₃) is added.

The invention can reduce the cost of the formation of a ZnO transparent conductive film by forming a ZnO transparent conductive film by the MOCVD (metal-organic chemical vapor deposition) method without adding (using) diborane (B₂H₆), which has been used as an additive in related-art deposition methods and is a special material gas whose handling necessitates a special apparatus. The ZnO transparent conductive film formed by this process of the invention can be equal in performance (resistivity and extinction coefficient) to ZnO transparent conductive films formed by a process in which high-purity diethylzinc is used as a raw material and diborane (B₂H₆), which is a special material gas whose handling necessitates a special apparatus, is added.

### BEST MODE FOR CARRYING OUT THE INVENTION

The invention relates to processes for producing a ZnO transparent conductive film in which low-purity diethylzinc (Zn(C₂H₅)₂) is used as a raw material to produce a ZnO transparent conductive film by the MOCVD (metal-organic chemical vapor deposition) method.
In general, in the case of forming a ZnO transparent conductive film by the chemical vapor deposition method (CVD method), the diethylzinc to be used as an organozinc-compound raw material therefor is of the kind called semiconductor grade, which has been highly purified and has apurityof 99.999-99.9999%. In the processes of the invention, however, use is made of low-purity diethylzinc which has been lowly purified, e.g., diethylzinc having a purity of 90% or higher or diethylzinc having a purity of 98% or higher.

A process of the invention, which is for forming a ZnO transparent conductive film by the MOCVD (metal-organic chemical vapor deposition) method, comprises using diethylzinc of 90-99.99% as a raw material and water vapor (H₂O) as an oxidizing agent, utilizing as a Group-III-element additive the triethylaluminum (Al (C₂H₅) ₃) contained as an impurity in the diethylzinc in an amount of 0.01-10%, and adding diborane (B₂H₆) as a Group-III-element additive to cause the diethylzinc, the water vapor (H₂O), the triethylaluminum, and the diborane to undergo a vapor-phase reaction and thereby produce a ZnO transparent conductive film. (Hereinafter, this process is referred to as deposition method I.)

In the deposition method I for forming a ZnO transparent conductive film described above, when diethylzinc having a purity of 98-99.99%, which is in a high-purity region among the usable diethylzinc purity region shown above, is used, then the triethylaluminum (Al (C₂H₅)₃) contained as an impurity in the diethylzinc in an amount of 0.01-2% is utilized as a Group-III-element additive and diborane (B₂H₆) is added as a Group-III-element additive to cause the diethylzinc, the water vapor (H₂O), the triethylaluminum, and the diborane to undergo a vapor-phase reaction and thereby produce a ZnO transparent conductive film. (Hereinafter, this process is referred to as deposition method II.)

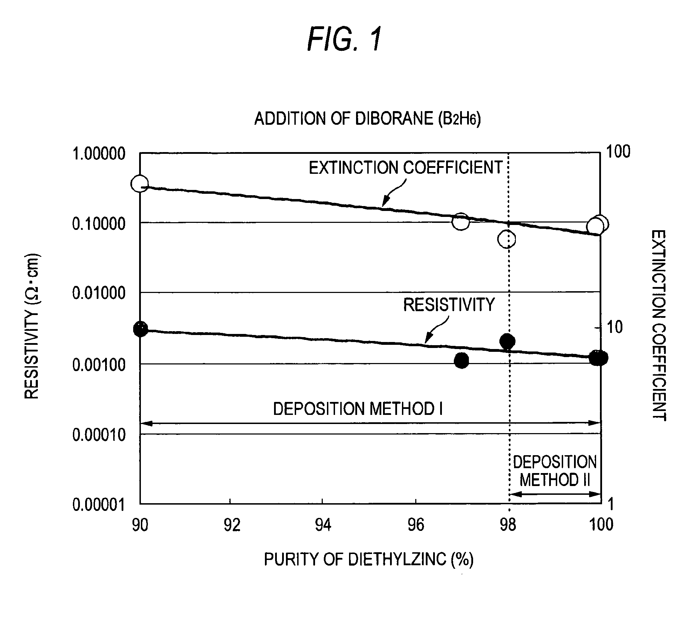

In the case where diborane (B₂H₆) is added for film formation as in the deposition method I and deposition method II, the resistivity and the extinction coefficient tend to increase and decrease, respectively, as the purity of the diethylzinc is reduced (triethylaluminum content is increased) to about 99%, as shown in Fig. 1. This is thought to be because the doping effect of boron B (proportion of boron incorporated) decreased due to the increased amount of the aluminum incorporated. When the purity is reduced to about 97%, aluminum is incorporated in a larger amount and, hence, the resistivity and the extinction coefficient decrease and increase, respectively. The films corresponding to these regions each is considered to have properties which make the film practically usable as a transparent conductive film.

ZnO transparent conductive films formedby the deposition method I (using diethylzinc having a purity of 90-99.99% as a raw material) can be utilized in the following applications. Those corresponding to the high-purity region are usable for current driven devices (large current amounts), e.g., solar cells, while those corresponding to low purities are usable for voltage driven devices (for small current amounts), e.g., liquid-crystal display panels and prevention of static buildup.
For example, a transparent conductive film having a thickness of about 1.4 µm obtained using diethylzinc having a purity of 98% had properties including a sheet resistance of 14.6 Ω/□ and a visible light transmittance of 90.1%. This film can be a practical transparent conductive film.

ZnO transparent conductive films formed by the deposition method II (using diethylzinc having a purity of 99.99-98% as a raw material) can be used for solar cells because they have a sheet resistance in the range of 2-20 Ω/□, which is required for solar cell use.
For example, when diethylzinc having a purity of 98% was used and diborane was added in an amount of about 20 sccm per 600 sccm of the diethylzinc in film formation, a transparent conductive film was obtained which had a thickness of about 1.4 µm and had a sheet resistance of 9 Ω/□ and a visible light transmittance of 89.4-%. These film properties can be regarded as almost equal to the properties of a transparent conductive film having a thickness of about 1.4 µm formed using diethylzinc having a purity of 99.999% as a raw material, which include a sheet resistance of 8.1 Ω/□ and a visible light transmittance of 88.1%. That transparent conductive film has performances sufficient for solar cell use.

Another process of the invention for forming a ZnO transparent conductive film by the MOCVD(metal-organic chemical vapor deposition) method (process in which diborane (B₂H₆) as a Group-III-element additive is not added) is shown below.
Diethylzinc having a low purity of 90-98% is used as a raw material and water vapor (H₂O) is used as an oxidizing agent. The triethylaluminum (Al(C₂H₅)₃) contained as an impurity in the diethylzinc in an amount of 2-10% is utilized as a Group-III-element additive. The diethylzinc, the water vapor (H₂O), and the triethylaluminum are caused to undergo a vapor-phase reaction to thereby produce a ZnO transparent conductive film without adding diborane (B₂H₆) as a Group-III-element additive. (Hereinafter, this process is referred to as deposition method III.)

In the deposition method III, the deposition is conducted at a substrate temperature of 150-190°C and a flow rate ratio of the carrier gas containing the diethylzinc to the carrier gas containing the water vapor (H₂O) in the range of 0.95-1.05.

Still another process of the invention for forming a ZnO transparent conductive film by the MOCVD (metal-organic chemical vapor deposition) method (process in which diborane (B₂H₆) as a Group-III-element additive is not added) is shown below.
Diethylzinc having a low purity of 99.99-98% is used as a raw material and water vapor (H₂O) is used as an oxidizing agent. The triethylaluminum (Al(C₂H₅)₃) contained as an impurity in the diethylzinc in an amount of 0.01-2% is utilized as a Group-III-element additive. The diethylzinc, the water vapor (H₂O), and the triethylaluminum are caused to undergo a vapor-phase reaction to thereby produce a ZnO transparent conductive film without adding diborane (B₂H₆) as a Group-III-element additive. (Hereinafter, this process is referred to as deposition method IV.)

In the deposition method IV, the deposition is conducted at a substrate temperature of 160-180°C and a flow rate ratio of the carrier gas containing the diethylzinc to the carrier gas containing the water vapor (H₂O) of about 1.0.

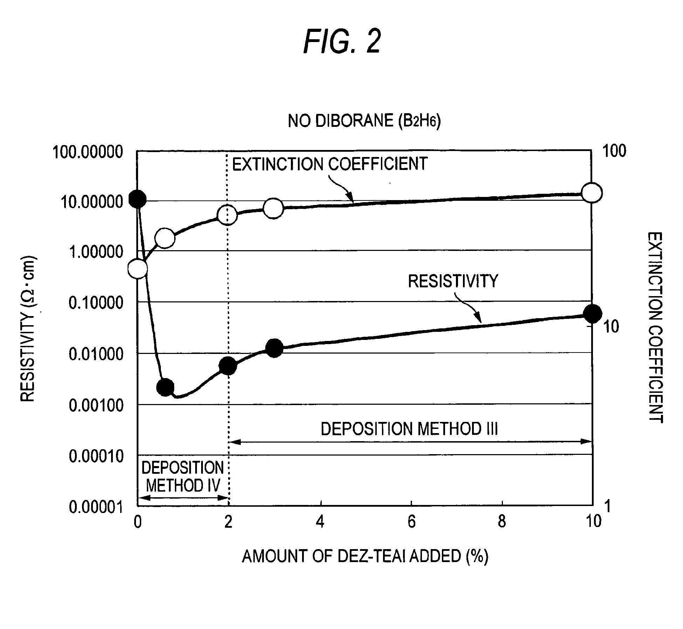

ZnO transparent conductive films formed by the deposition method IV have properties such as those shown in Fig. 2, and can be used in applications such as low-resistance transparent conductive films for CIS type thin-film solar cells.

In the case of conducting deposition without adding diborane (B₂H₆) as in the deposition method III and deposition method IV, the resistivity is reduced to about 1/5,000 by the addition (presence) of a slight amount of triethylaluminum (TEA1) without necessitating the addition of diborane (B₂H₆), as shown in Fig. 2. When TEAl is added in a larger amount, the resistivity tends to increase gradually due to a decrease in film quality caused by an excess of the impurity. However, such films can function as sufficiently practicable transparent conductive films in some applications. As the amount of the triethylaluminum (TEA1) added increases, the extinction coefficient increases because light absorption by the additive increases. However, from the experimental data given above, it is presumed that a conductive thin film retaining transparency can be formed when the amount of the TEA1 added is up to about 10%.

ZnO transparent conductive films formed by the deposition method III (using diethylzinc having a purity of 90-98% as a raw material; amount of triethylaluminum (TEA1) added, 10-2%) have properties such as those shown in Fig. 2. These films have a relatively high resistance (10-1,000 Ω/□) and are usable in applications such as liquid-crystal displays, antifogging glasses, and antistatic glasses.
For example, a transparent conductive film having a thickness of about 1.11 µm formed by the method in which 3% TEAl was added (contained) (diethylzinc having a purity of 97% was used) had a sheet resistance of 107 Ω/□ and a visible light transmittance of 88.9%. In this case, when a film having a higher transmittance is necessary, a film thickness reduction to about 0.1 µm is expected to attain a sheet resistance of about 1,000 Ω/□ and a visible light transmittance of 97% or higher.

ZnO transparent conductive films formed by the deposition method IV (using diethylzinc having a purity of 99.99-98% as a raw material; amount of triethylaluminum (TEA1) added, 2-0.01%) have properties such as those shown in Fig. 2. These films are usable in applications such as low-resistance transparent conductive films for, e.g., CIS type thin-film solar cells.
For example, a transparent conductive film having a thickness of about 1.16 µm formed by the method in which 0.6% TEAL was added (contained) (diethylzinc having a purity of 99.4% was used) had a sheet resistance of 18 Ω/□ and a visible light transmittance of 91.7%. Since the transparent conductive films in use for solar cells are ones having a sheet resistance of about 2-20 Ω/□, that transparent conductive film is considered to be practically usable for solar cells.

### BRIEF DESCRIPTION OF THE DRAWINGS

[Fig. 1] Fig. 1 is a presentation showing changes in resistivity and extinction coefficient with changing diethylzinc purity in the case where diborane is added in a process of the invention for forming a ZnO transparent conductive film by the MOCVD (metal-organic chemical vapor deposition) method.
[Fig. 2] Fig. 2 is a presentation showing changes in resistivity and extinction coefficient with changing triethylaluminum (TEA1) addition amount in the diethylzinc in the case where no diborane is added in a process of the invention for forming a ZnO transparent conductive film by the MOCVD (metal-organic chemical vapor deposition) method.

### DESCRIPTION OF SIGNS

I: deposition method using diethylzinc of 90-99.99% as raw material, water vapor as oxidizing agent, and TEAL and diborane as additives
II: deposition method using diethylzinc of 99.99-98% as raw material, water vapor as oxidizing agent, and TEAl and diborane as additives
III: deposition method using diethylzinc of 90-98% as raw material, water vapor as oxidizing agent, and TEAL as additive
IV: deposition method using diethylzinc of 99.99-98% as rawmaterial, water vapor as oxidizing agent, and TEAl as additive TEA1: triethylaluminum

## Claims

1. A process for producing a ZnO transparent conductive film in which low-purity diethylzinc (Zn(C₂H₅)₂) is used as a raw material to produce a ZnO transparent conductive film by the MOCVD (metal-organic chemical vapor deposition) method, wherein the process comprises using diethylzinc of 90-99.99% as a raw material and water vapor (H₂O) as an oxidizing agent, utilizing as a Group-III-element additive the triethylaluminum (Al(C₂H₅)₃) contained as an impurity in the diethylzinc in an amount of 0.0.1-10%, and adding diborane (B₂H₆) as a Group-III-element additive to cause the diethylzinc, the water vapor (H₂O), the triethylaluminum, and the diborane to undergo a vapor-phase reaction and thereby produce a ZnO transparent conductive film by the MOCVD (metal-organic chemical vapor deposition) method.

2. A process for producing a ZnO transparent conductive film in which low-purity diethylzinc (Zn(C₂H₅)₂) is used as a raw material to produce a ZnO transparent conductive film by the MOCVD (metal-organic chemical vapor deposition) method, wherein the process comprises using diethylzinc of 99.99-98% as a raw material and water vapor (H₂O) as an oxidizing agent, utilizing as a Group-III-element additive the triethylaluminum (Al(C₂H₅)₃) contained as an impurity in the diethylzinc in an amount of 0.01-2%, and adding a slight amount of diborane (B₂H₆) as a Group-III-element additive to cause the diethylzinc, the water vapor (H₂O), the triethylaluminum, and the diborane to undergo a vapor-phase reaction and thereby produce a ZnO transparent conductive film by the MOCVD (metal-organic chemical vapor deposition) method.

3. A process for producing a ZnO transparent conductive film in which low-purity diethylzinc (Zn(C₂H₅)₂) is used as a raw material to produce a ZnO transparent conductive film by the MOCVD (metal-organic chemical vapor deposition) method, wherein the process comprises using diethylzinc of 90-98% as a raw material and water vapor (H₂O) as an oxidizing agent and utilizing as a Group-III-element additive the triethylaluminum (Al(C₂H₅)₃) contained as an impurity in the diethylzinc in an amount of 2-10% to cause the diethylzinc, the water vapor (H₂O), and the triethylaluminum to undergo a vapor-phase reaction and thereby produce a ZnO transparent conductive film by the MOCVD (metal-organic chemical vapor deposition) method without adding diborane (B₂H₆) as a Group-(III-element additive.

4. The process for producing a ZnO transparent conductive film by the MOCVD (metal-organic chemical vapor deposition) method according to claim 3, wherein the deposition is conducted at a substrate temperature of 150-190°C and a flow rate ratio of the carrier gas containing the diethylzinc to the carrier gas containing the water vapor (H₂O) in the range of 0.95-1.05.

5. A process for producing a ZnO transparent conductive film in which low-purity diethylzinc (Zn(C₂H₅)₂) is used as a raw material to produce a ZnO transparent conductive film by the MOCVD (metal-organic chemical vapor deposition) method, wherein the process comprises using diethylzinc of 99.99-98% as a raw material and water vapor (H₂O) as an oxidizing agent and utilizing, as a Group-III-element additive the triethylaluminum (Al(C₂H₅)₃) contained as an impurity in the diethylzinc in an amount of 0.01-2% to cause the diethylzinc, the water vapor (H₂O), and the triethylaluminum to undergo a vapor-phase reaction and thereby produce a ZnO transparent conductive film by the MOCVD (metal-organic chemical vapor deposition) method without adding diborane (B₂H₆) as a Group-(III-element additive.

6. The process for producing a ZnO transparent conductive film by the MOCVD (metal-organic chemical vapor deposition) method according to claim 5, wherein the deposition is conducted at a substrate temperature of 160-180°C and a flow rate ratio of the carrier gas containing the diethylzinc to the carrier gas containing the water vapor (H₂O) of about 1.0.
